# EUROPÄISCHE PATENTSCHRIFT

(11) **EP 0 953 848 B1**
(45) Veröffentlichungstag und Bekanntmachung des Hinweises auf die Patenterteilung: **28.07.2004**
(21) Anmeldenummer: 99102191.6
(22) Anmeldetag: 04.02.1999
(51) Int. Cl.: G01R 31/30, G11C 29/00

(54) **Verfahren zum Parametrieren einer integrierten Schaltungsanordnung und integrierte Schaltungsanordnung hierfür**
Method for setting of parameters of an integrated circuit and corresponding circuit
Procédé de paramétrage d'un circuit intégré et le circuit intégré correspondant

(30) Priorität: 30.04.1998 DE 19819265
(43) Veröffentlichungstag der Anmeldung: 03.11.1999
(73) Patentinhaber: Micronas GmbH, 79108 Freiburg (DE)
(72) Erfinder: Hummel, Ulrich Helmut, Dipl.-Ing., 79331 Teningen (DE)
(74) Vertreter: Patentanwälte Westphal, Mussgnug & Partner

(56) Entgegenhaltungen:
- US-A- 5 544 107
- US-A- 5 732 207

## Beschreibung

Die Erfindung betrifft ein Verfahren zum Parametrieren einer integrierten Schaltungsanordnung gemäß den Merkmalen des Oberbegriffs des Anspruchs 1 sowie eine integrierte Schaltungsanordnug hierfür.

Verfahren zum Parametrieren von integrierten Schaltungsanordnungen sind z. B. aus DE 195 48 984 A1 bekannt. Der Parametriervorgang dient dazu, die integrierte Schaltungsanordnung nach ihrer Fertigstellung oder während ihrer Montage auf Schaltungsplatinen abzugleichen und zu personalisieren. Ein solcher Abgleich oder eine Personalisierung der integrierten Schaltungsanordnung ist notwendig, um bestimmte Schaltungsteile innerhalb der integrierten Schaltungsanordnung auf vorgegebene Werte zu setzen oder mit vorgegebenen Werten, z. B. Kennziffern für den jeweiligen integrierten Schaltkreis zu versehen. So kann beispielsweise in der integrierten Schaltungsanordnung ein Oszillator vorhanden sein, dessen Taktfrequenz auf eine bestimmte Frequenz eingestellt werden muß. Darüber hinaus können in der integrierten Schaltungsanordnung auch bestimmte Eigenschaften eines etwaig vorhandenen Digital-Analog oder Analog/Digital-Wandlers durch den Parametriervorgang eingestellt werden.

Bekannte Verfahren zum Parametrieren solcher integrierten Schaltungsanordnungen bestehen beispielsweise im sogenannten Zenerzapping. Problematisch bei dem bekannten Zenerzapping ist die Notwendigkeit von verhältnismäßig vielen Anschlußklemmen an der integrierten Schaltungsanordnung. Das Zenerzapping ist nachteiligerweise nur schwer beherrschbar und bietet wenig Programmiermöglichkeiten. Darüber hinaus ist mit dem Zenerzapping eine Parametrierung bei der Montage der integrierten Schaltungsanordnung ausgeschlossen.

Eine andere Möglichkeit zum Parametrieren der integrierten Schaltungsanordnung besteht darin, für den Parametriervorgang separate Anschlußklemmen zum Anlegen eines bestimmten Busprotokolls vorzusehen. Nachteilig an dieser Lösungsmöglichkeit ist ebenfalls die Notwendigkeit, verhältnismäßig viele zusätzliche Anschlußklemmen verwenden zu müssen und damit die Kosten für die Herstellung solcher integrierten Schaltungsanordnungen zu erhöhen. Darüber hinaus sind mit dem Einsatz zusätzlicher Anschlußklemmen auch Zuverlässigkeitsprobleme der integrierten Schaltungsanordnung verbunden.

Schließlich ist es bekannt, zum Parametrieren der integrierten Schaltungsanordnungen spezielle, serielle Protokolle zu verwenden. Solche seriellen Protokolle zur Parametrierung zeichnen sich durch eine verhältnismäßig niedrige Fehlertoleranz auf. Darüber hinaus müssen solche Busprotokolle synchron zur Oszillatorfrequenz innerhalb der integrierten Schaltungsanordnung sein. Schließlich fordern solche speziellen seriellen Protokolle höhere Timing-Anforderungen.

Der Erfindung liegt deshalb die Aufgabe zugrunde, ein Verfahren zum Parametrieren einer integrierten Schaltungsanordnung anzugeben, die keine über die im Normalbetrieb ohnehin vorhandenen zusätzlichen Anschlußklemmen erfordert. Die Erfindung hat weiterhin das Ziel eine integrierte Schaltungsanordnung für ein solches Verfahren anzugeben.

In einer Weiterbildung der Erfindung soll sich darüber hinaus das Verfahren dadurch auszeichnen, daß verhältnismäßig große Schwankungen der Taktfrequenz des Busprotokolls für die Parametrierung durch die integrierte Schaltungsanordnung tolerierbar sind. Ein spezielles, fehlergeschütztes Busprotokoll soll hierfür ebenfalls angegeben werden.

Das Hauptziel der Erfindung wird durch ein Verfahren erreicht, das die Merkmale des Anspruchs 1 aufweist.

Eine integrierte Schaltungsanordnung zum Durchführen dieses Verfahrens zeichnet sich durch die Merkmale des Anspruchs 10 aus.

Weiterbildungen der Erfindung sind Gegenstand der auf die unabhängigen Ansprüche zurückbezogenen Unteransprüche.

Das Verfahren zum Parametrieren einer integrierten Schaltungsanordnung zeichnet sich also im wesentlichen dadurch aus, daß die Parametrierung durch Anlegen eines digitalen Start-Kommando-Signals mit nachfolgenden Parametrierdaten an der Versorgungsspannungsklemme und/oder Ausgangsklemme der integrierten Schaltungsanordnung durchgeführt wird. Hierbei liegt während des Parametriervorgangs dauerhaft ein über dem normalen Betriebsspannungspegel der integrierten Schaltungsanordnung liegender Spannungspegel an der Versorgungsspannungsklemme und/oder Ausgangsklemme an. Dieses erhöhte Spannungspotential an den erwähnten Klemmen wird von einer innerhalb der integrierten Schaltungsanordnung angeordneten Detektoreinrichtung bzw. von einem Komparator erfaßt und für den Parametriervorgang kennzeichnend ausgenutzt.

Das erfindungsgemäße Verfahren nutzt vorteilhafterweise die ohnehin an der integrierten Schaltungsanordnung angeordneten Klemmen zur Parametrierung aus. Es sind folglich keine zusätzlichen Klemmen für die Parametrierung erforderlich, was einerseits den Herstellaufwand für die integrierte Schaltungs-anordnung erheblich vermindert und anderseits auch die Zuverlässigkeit einer solchen integrierten Schalcungsanordnung im Vergleich zu integrierten Schaltungsanordnungen mit zasätzlichen Anschlüssen für die Parametrierung erhöht.

In einer Weiterbildung der Erfindung ist das Parametriersignal durch einen Code gebildet, der nach jedem Bit einen Flankenwechsel vorsieht. Vorzugsweise ist ein erster logischer Zustand eines Bits durch einen zusätzlichen Flankenwechsel in etwa der Mitte der Bitdauer und ein zweiter logischer Zustand eines Bits durch ein während der Bitdauer gleichbleibendes Signal bestimmt.

In der integrierten Schaltungsanordnung ist hierfür ein Oszillator und ein Interface angeordnet, durch welche eine vorgegebene variable Taktfrequenz des Parametriersignals verarbeitbar ist, indem zu Beginn jedes Bits ein zeitliches Fenster festgelegt wird, innerhalb dessen ein Flankenwechsel als Bitende zu erwarten ist.

Vorzugsweise kann nach dem Auftreten mindestens eines das Bitende markierenden Flankenwechsels die Zeitdauer eines Bits bestimmt und der nächste zu erwartende Flankenwechsel um diese Zeitdauer versetzt erwartet werden. Die Zeitdauer für ein Bit kann in einer Weiterbildung der Erfindung aus dem Mittelwert von mindestens zwei Bitdauern bestimmt werden.

Die integrierte Schaltungsanordnung zur Durchführung des Verfahrens weist zumindest eine Versorgungsspannungsklemme, eine Bezugspotentialklemme und eine Ausgangsklemme sowie einen Oszillator und eine an den Oszillator angeschlossene Interface-Einrichtung und eine Speichereinrichtung auf. Des weiteren ist eine zwischen die Versorgungsspannungsklemme und die Interface-Einrichtung geschaltete Detektoreinrichtung bzw. ein Komparator vorgesehen und die Interface-Einrichtung mit der Ausgangsklemme der Speichereinrichtung in Verbindung. Der Oszillator innerhalb der integrierten Schaltungsanordnung dient als Zeitbasis zur Protokolldekodierung des Parametriervorgangs sowie zur Generierung von einem geeigneten Takt für die an der Ausgangsklemme der integrierten Schaltungsanordnung anzulegenden Ausgangssignale.

Die Detektoreinrichtung bzw. der Komparator detektiert die unterschiedlichen Betriebsspannungspegel an der Versorgungsspannungsklemme und stellt folglich fest, ob ein "normaler" Betrieb der integrierten Schaltungsanordnung oder ein Parametriervorgang vorgesehen ist. Die Interface-Einrichtung erkennt den während des Paramentriervorganges einlaufenden Datenstrom, führt hierauf Kommandos aus und generiert die zugehörende Antwort. Die Speichereinrichtung speichert dauerhaft empfangene Einstellwerte, weil die Speichereinrichtung vorzugsweise nichtflüchtig ausgebildet ist.

Die Erfindung wird nachfolgend anhand eines Ausführungsbeispieles im Zusammenhang mit Figuren näher erläutert. Es zeigen:
- Figur 1: ein Blockschaltbild der Schaltungsanordnung nach der Erfindung mit angeschlossenem Protokollgenerator und Steuerrechner bzw. Testautomat,
- Figur 2: beispielhaft mögliche logische Zustände eines Bits eines Busprotokolls zur Parametrierung der integrierten Schaltungsanordnung von Figur 1, und
- Figur 3: beispielhaft mögliche Busprotokolle für ein Lese- und Schreibkommando, ein Programmier/Sperrkommando, ein Schreib-/Programmier/Sperr-Kommando und ein Lese-Kommando.

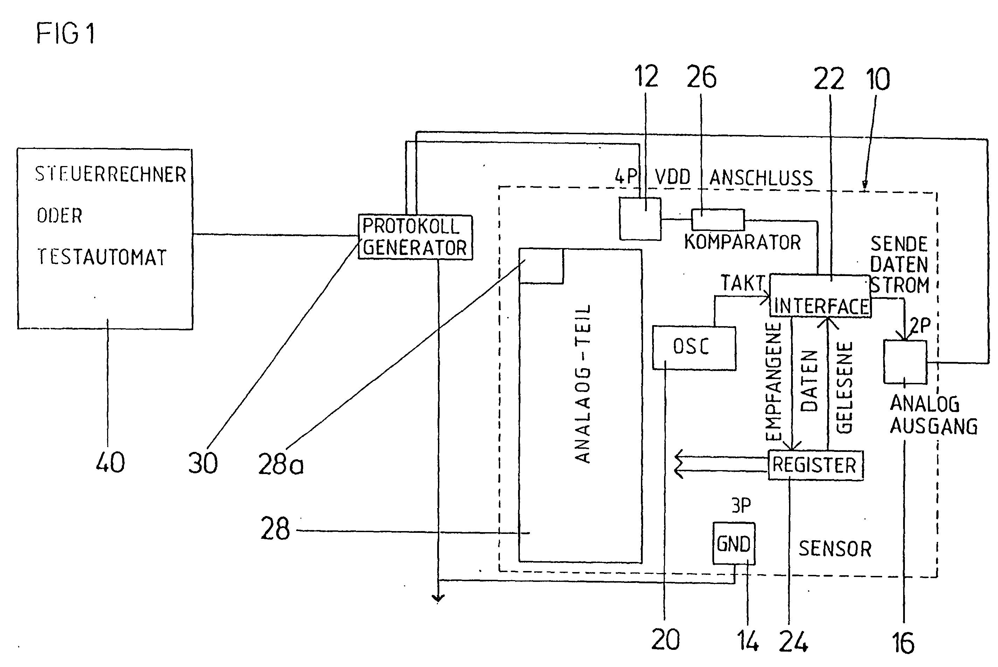

In Figur 1 ist das Blockschaltbild einer integrierten Schaltungsanordnung nach der Erfindung dargestellt. Die integrierte Schaltungsanordnung ist mit dem Bezugszeichen 10 versehen und im Ausführungsbeispiel eine integrierte Schaltungsanordnung mit einem integrierten Sensor 28a, der in einem analogen Schaltungsteil 28 der integrierten Schaltungsanordnung 10 untergebracht ist. Der Sensor 28a kann beispielsweise ein Hall-Sensor sein.

Die integrierte Schaltungsanordnung 10 weist im vorliegenden Ausführungsbeispiel drei Anschlußklemmen auf, nämlich eine Versorgungsspannungsklemme 12, eine Bezugspotentialklemme 14 und eine Ausgangsklemme 16, die im vorliegenden Ausführungsbeispiel als Ausgangsklemme für ein analoges Signal vorgesehen ist. Des weiteren verfügt die integrierte Schaltungsanordnung über einen internen Oszillator 20 der einer Interface-Einrichtung 22 ein Taktsignal zur Verfügung stellt. Die Interface-Einrichtung 22 ist mit einer Speichereinrichtung 24, z. B. einem Register, in Verbindung, um die Speichereinrichtung 24 mit Daten zu beschreiben oder um Daten aus dieser Speichereinrichtung 24 auszulesen. Des weiteren steht diese Interface-Einrichtung 22 über einen Komparator 26 bzw. eine Detektoreinrichtung mit der Versorgungsspannungsklemme 12 in Verbindung. Schließlich ist die Interface-Einrichtung mit der Ausgangsklemme 16 in Kontakt.

Die Detektoreinrichtung bzw. der Komparator 26 stellt fest, ob ein "normaler" Betrieb der integrierten Schaltungsanordnung 10 durchgeführt wird, der beispielsweise durch Anlegen eines weitgehend annähernd gleichbleibenden +5V-Signales bestimmt ist, oder ob ein Parametriervorgang eingeleitet wird. Der Parametriervorgang zeichnet sich dadurch aus, daß an den Versorgungsspannungsklemme 12 eine deutlich über der normalen Betriebsspannung von +5V liegender Spannungspegel ansteht.

Sofern ein solcher Parametriervorgang von dem Komparator 26 detektiert wird, sorgt die Interface-Einrichtung 22 dafür, daß die Speichereinrichtung 24 mit dem durch die Parametrierdaten empfangenen Daten direkt beschrieben wird oder daß aus diesen empfangenen Parametrierdaten bestimmte in der Speichereinrichtung 24 abgelegten Daten ausgelesen werden. Diese in der Speichereinrichtung 24 abgelegten und durch den Parametriervorgang ausgelösten Daten stellen, wie durch die Pfeile in Figur 1 verdeutlicht, den analogen Schaltungsteil 28 ein bzw. gleichen diesen ab. Des weiteren können diese Daten dazu verwendet werden, die integrierte Schaltungsanordnung 10 zu personalisieren, also mit einer bestimmten Kennziffer zu versehen, um die integrierte Schaltungsanordnung später eindeutig von anderen, gleich aufgebauten integrierten Schaltungsanordnungen unterscheiden zu können. Schließlich ist es mit den durch den Parametriervorgang ausgelösten Daten auch möglich, die Oszillatorfrequenz des Oszillators 20 zu variieren und einzustellen.

Im Ausführungsbeispiel von Figur 1 ist das Blockschaltbild für einen durchzuführenden Parametriervorgang der integrierten Schaltungsanordnung 10 dargestellt. Deshalb ist zusätzlich noch ein Steuerrechner oder Testautomat 40 gezeigt, der mit einem Protokollgenerator 30 in Verbindung steht. Der Protokollgenerator 30 steht sowohl mit der Versorgungsspannungsklemme 12 als auch mit der Ausgangsklemme 16 der integrierten Schaltungsanordnung 10 in Kontakt. Der Protokollgenerator 30 erzeugt einen Datenstrom zur Versorgungsspannungsklemme 12 der integrierten Schaltungsanordnung 10 und demoduliert zusätzlich das an der Ausgangsklemme 16 der integrierten Schaltungsanordnung 10 anstehende Antwortsignal, das im Steuerrechner bzw. im Testautomat 40 ausgewertet wird. Selbstverständlich ist es erforderlich, daß der Protokollgenerator 30 für den Parametriervorgang dauerhaft einen Spannungspegel an die Versorgungsspannungsklemme 12 anlegt, der deutlich vom "normalen" Betriebsspannungspegel für die integrierte Schaltungsanordnung 10 abweicht, insbesondere diesen deutlich übersteigt.

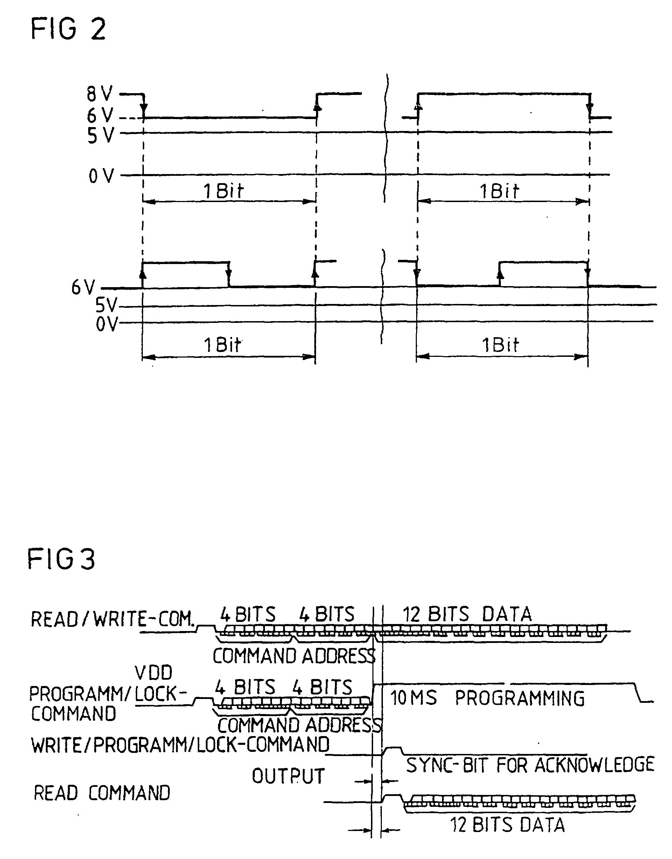

In Figur 2 sind mögliche logische Zustände von Bits dargestellt, die vorzugsweise zur Parametrierung der integrierten Schaltungsanordnung 10 eingesetzt werden. Vorzugsweise sind die logischen Zustände so gewählt, daß auf jeden Fall zu Beginn und am Ende des Bits, gleich welchen logischen Zustand dieses Bit einnimmt, ein Flankenwechsel stattfindet.

In Figur 2 oben sind die möglichen Zustände für ein Bit, das einen ersten logischen Zustand einnimmt, dargestellt. Es ist deutlich zu erkennen, daß während der gesamten Bitdauer entweder gleichbleibend ein logischer Low-Pegel oder ein logischer High-Pegel ansteht. Ein erster logischer Pegel, der beispieisweise der Low-Pegel eines Bits sein kann, ist beispielsweise durch ein während der gesamten Bitdauer gleichbleibendes Signal gekennzeichnet. Dieses Signal kann, wie in Figur 2 links oben dargestellt, beispielsweise durch ein dauerhaftes +6V Signal markiert sein, an dessen Anfang und Ende ein Flankenwechsel auf +8V stattfindet. Des weiteren kann dieser erste logische Zustand auch durch ein während der gesamten Bitdauer gleichbleibendes, auf +8V liegendes Spannungssignal markiert sein. Am Anfang und Ende dieses +8V Signals findet ein Flankenwechsel auf +6V statt. Auf jeden Fall ist sichergestellt, daß während der gesamten Bitdauer stets ein deutlich über dem "normalen" Spannungspegel von beispielsweise +5V liegender Spannungspegel ein Bit kennzeichnet.

Der zweite logische Zustand unterscheidet sich vom ersten logischen Zustand dadurch, daß innerhalb einer Bitdauer ein zusätzlicher Flankenwechsel stattfindet.

Dies ist in Figur 2 unten für zwei mögliche Bit, die den zweiten logischen Zustand einnehmen, dargestellt. Es ist erkennbar, daß, gleich von welchem Spannungspegel diese Bits ausgehen, auf jeden Fall sichergestellt ist, daß zu Beginn und am Ende jedes Bits ein Flankenwechsel auftritt.

Dieser auf jeden Fall auftretende Flankenwechsel zu Beginn und am Ende jeden Bits wird ausgenutzt, um bei einem in der integrierten Schaltungsanordnung einlaufenden Parametriersignal, dessen Taktfrequenz unbekannt ist, eine Detektion des Parametriersignals zu ermöglichen. Anhand der auftretenden Flankenwechsel ist nämlich eindeutig bestimmbar, welche Taktfrequenz das einlaufende Parametriersignal tatsächlich aufweist. Taktfrequenztoleranzen des Parametriersignals sind deshalb erfindungsgemäß tolerierbar.

Es wird nämlich zu Beginn jeden Bits, was anhand einer Flanke detektiert wird, ein zeitliches Fenster festgelegt, innerhalb dem ein Flankenwechsel als Bitende zu erwarten ist. Vorzugsweise ist dieses zeitliche Fenster so definiert, daß es zwischen der maximal zulässigen Frequenz und der minimal zulässigen Frequenz des Parametriersignals liegt, wobei die maximale Frequenz des Parametriersignals etwas größer als die halbe minimale Frequenz des Parametriersignals ist.

Nach Auftreten mindestens eines das Bitende markierenden Flankenwechsels wird so die Zeitdauer eines Bits bestimmt und der nächste zu erwartende Flankenwechsel um diese Zeitdauer versetzt erwartet.

Zweckmäßigerweise wird die Zeitdauer für ein Bit aus dem Mittelwert von mindestens zwei Bitdauern bestimmt.

In Figur 3 sind mögliche Busprotokolle zur Parametrierung der integierten Schaltungsanordnung dargestellt. Das Lese-Schreibkommando ist beispielsweise durch ein Syncbit mit nachfolgenden vier Kommandobits sowie vier Adressbits und nachfolgenden 12 Bitdaten gekennzeichnet. Das Programmier-Sperr-Kommando ist beispielsweise durch ein anfängliches Syncbit mit nachfolgenden vier Befehlsbits, vier Adressbits und einer vorgegebenen Programmierzeit gekennzeichnet. Die Programmierzeit ist beispielsweise 10ms lang. Das Schreib-Programmier-Sperr-Kommando ist durch ein einzelnes Synchronisationsbit gekennzeichnet. Das Lese-Kommando ist durch ein Synchronisationsbit mit nachfolgenden 12 Bitdaten festgelegt.

Vorteilhaft bei der erfindungsgemäßen Parametrierung ist die Tatsache, daß im Vergleich zu sonst üblichen Verfahren, wie z. B. dem eingangs erwähnten Zenerzapping, keine zusätzlichen Anschlußklemmen für die Parametrierung in der integrierten Schaltungsanordnung vorgesehen werden müssen. Darüber hinaus kann ein einfacher On-Chip-Oszillator mit verhältnismäßig hoher Fehlertoleranz innerhalb der integrierten Schaltungsanordnung vorgesehen werden. Schließlich zeichnet sich die erfindungsgemäße Parametrierung durch kurze Programmierzeiten aus und durch eine einfache Realisierung des Protokolls für die Parametrierung, wobei die Parametrierung mit einer verhältnismäßig reduzierten Geschwindigkeit durchgeführt werden kann.

### Bezugszeichenliste

- 10: Integrierte Schaltungsanordnung
- 12: Versorgungsspannungsklemme
- 14: Bezugspotentialklemme
- 16: Ausgangsklemme
- 20: Oszillator
- 22: Interface-Einrichtung
- 24: Register-Speichereinrichtung
- 26: Komparator, Detektoreinrichtung
- 28: Analoger Schaltungsteil
- 28a: Sensor
- 30: Protokollgenerator
- 40: Steuerrechner, Testautomat

## Patentansprüche

1. Verfahren zum Parametrieren einer integrierten Schaltung (10), die eine Versorgungsspannungsklemme (12), eine Bezugspotentialklemme (14) sowie eine Ausgangsklemme (16) aufweist,
**dadurch gekennzeichnet,**
**daß** die Parametrierung durch Anlegen eines digitalen Startkommandosignales mit nachfolgenden Paramentrierdaten an die Versorgungsspannungsklemme (12) und/oder Ausgangsklemme (16) durchgeführt wird, wobei während des Paramentriervorganges dauerhaft ein über dem normalen Betriebsspannungspegel der integrierten Schaltung (10) liegender Spannungspegel an der Versorgungsspannungsklemme (12) und/oder Ausgangsklemme (16) ansteht, was von einer Detektoreinrichtung (26) innerhalb der integrierten Schaltung (10) erfaßt wird.

2. Verfahren nach Anspruch 1,
**dadurch gekennzeichnet,**
**daß** das Parametriersignal durch einen Code gebildet ist, der nach jedem Bit einen Flankenwechsel vorsieht.

3. Verfahren nach Anspruch 2,
**dadurch gekennzeichnet,**
**daß** ein erster logischer Zustand eines Bits durch einen zusätzlichen Flankenwechsel in etwa der Mitte der Bitdauer und ein zweiter logischer Zustand eines Bits durch ein währen der Bitdauer gleichbleibendes Signal bestimmt ist.

4. Verfahren nach Anspruch 2 oder 3,
**dadurch gekennzeichnet,**
**daß** in der integrierten Schaltung (10) ein Oszillator (20) und ein Interface (22) angeordnet sind, durch welche eine vorgegebene variable Taktfrequenz des Parametriersignales verarbeitet wird, indem zu Beginn jedes Bits ein zeitliches Fenster festgelegt wird, innerhalb der ein Flankenwechsel als Bitende zu erwarten ist.

5. Verfahren nach Anspruch 4,
**dadurch gekennzeichnet,**
**daß** nach Auftreten mindestens eines das Bitende markierenden Flankenwechsels die Zeitdauer eines Bits bestimmt und der nächste zu erwartende Flankenwechsel um diese Zeitdauer versetzt erwartet wird.

6. Verfahren nach Anspruch 5,
**dadurch gekennzeichnet,**
**daß** die Zeitdauer für ein Bit aus dem Mittelwert von mindestens zwei aufeinanderfolgenden Bitdauern bestimmt wird.

7. Verfahren nach einem der Ansprüche 1 bis 6,
**dadurch gekennzeichnet,**
**daß** die integrierte Schaltung (10) einen nichtflüchtigen Speicher (24) aufweist, in welchem eine Einstellvorschrift für mindestens eine zu parametrierende Schaltungskomponente (28) abgelegt ist, und der Einstellvorgang mit dieser Einstellvorschrift durch die Parametrierdaten auslösbar ist.

8. Verfahren nach einem der Ansprüche 1 bis 7,
**dadurch gekennzeichnet,**
**daß** an der Ausgangsklemme (16) der integrierten Schaltung (10) ein den Parametriervorgang bestätigendes Signal abgreifbar ist.

9. Verfahren nach einem der Ansprüche 1 bis 8,
**dadurch gekennzeichnet,**
**daß** der Parametriervorgang Parametrieradressen aufweist zur Kennzeichnung der integrierten Schaltung (10).

10. Integrierte Schaltungsanordnung zur Durchführung des Verfahrens nach einem der Ansprüche 1 bis 9,
**dadurch gekennzeichnet,**
**daß** eine Versorgungsspannungsklemme (12), eine Bezugspotentialklemme (14) und eine Ausgangsklemme (16) vorgesehen sind sowie ein Oszillator (20) und eine an den Oszillator (20) angeschlossene Interface-Einrichtung (22), und daß die Schaltungsanordnung weiterhin eine Speichereinrichtung (24) und einen zwischen die Versorgungsspannungsklemme (12) und die Interface-Einrichtung (22) geschalteten Komparator bzw. Detektoreinrichtung (26) aufweist, wobei die Interface-Einrichtung (22) mit der Ausgangsklemme (16) und der Speichereinrichtung (24) in Verbindung steht.

11. Integrierte Schaltungsanordnung nach Anspruch 10,
**dadurch gekennzeichnet,**
**daß** die integrierte Schaltungsanordnung einen mit der Speichereinrichtung (24) verbundenen analogen Schaltungsteil (28) zur Einstellung des analogen Schaltungsteils (28) nach Maßgabe der Parametrierdaten aufweist.

12. Integrierte Schaltungsanordnung nach Anspruch 10 oder 11, **dadurch gekennzeichnet,**
**daß** der Komparator bzw. die Detektoreinrichtung (26) eine Schwellenspannung von etwa +5V aufweist.

13. Integrierte Schaltungsanordnung nach einem der Ansprüche 10 bis 12,
**dadurch gekennzeichnet,**
**daß** die Speichereinrichtung (24) eine nichtflüchtige Speichereinrichtung ist.

14. Integrierte Schaltungsanordnung nach einem der Ansprüche 10 bis 13,
**dadurch gekennzeichnet,**
**daß** die integrierte Schaltungsanordnung mindestens einen Sensor (28a), insbesondere einen Hall-Sensor, aufweist.

15. Integrierte Schaltungsanordnung nach einem der Ansprüche 10 bis 14,
**dadurch gekennzeichnet,**
**daß** ein an die Versorgungsspannungsklemme (12) und/oder die Ausgangsklemme (16) anzulegendes Parametrierkommando durch ein Syncbit mit nachfolgenden Befehlsbits, Adressbits und Datenbits bestimmt ist.

16. Integrierte Schaltungsanordnung nach Anspruch 15,
**dadurch gekennzeichnet,**
**daß** dem Syncbit vier Befehlsbits, vier Adressbits und zwölf Datenbits folgen.

## Claims

1. A method for setting the parameters of an integrated circuit (10), which comprises a supply voltage terminal (12), a reference potential terminal (14) and also an output terminal (16),
**characterised in that** setting of parameters is carried out by applying a digital start command signal with following parameter-setting data to the supply voltage terminal (12) and or output terminal (16), wherein during the parameter-setting operation a voltage level lying above the normal operating voltage level of the integrated circuit (10) is permanently present at the supply voltage terminal (12) and/or output terminal (16), which is detected by a detector device (26) inside the integrated circuit (10).

2. A method according to Claim 1,
**characterised in that** the parameter-setting signal is formed by a code which provides an edge change after each bit.

3. A method according to Claim 2,
**characterised in that** a first logic state of a bit is determined by an additional edge change in roughly the centre of the bit duration and a second logic state of a bit is determined by a signal remaining constant during the bit duration.

4. A method according to Claim 2 or 3,
**characterised in that** disposed in the integrated circuit (10) are an oscillator (20) and an interface (22), by which a predetermined variable clock frequency of the parameter-setting signal is processed by a time window being created at the start of each bit, inside which an edge change as the bit end is to be expected.

5. A method according to Claim 4,
**characterised in that** after the occurrence of at least one edge change marking the bit end, the duration of a bit is determined and the next edge change to be expected is expected displaced by this duration.

6. A method according to Claim 5,
**characterised in that** the duration for a bit is determined from the average of at least two successive bit durations.

7. A method according to one of Claims 1 to 6,
**characterised in that** the integrated circuit (10) comprises a non-volatile memory (24), in which an adjustment specification for at least one circuit component (28) for which parameters are to be set is deposited, and the adjustment operation can be triggered with this adjustment specification by the parameter-setting data.

8. A method according to one of Claims 1 to 7,
**characterised in that** a signal confirming the parameter-setting operating can be tapped at the output terminal (16) of the integrated circuit (10).

9. A method according to one of Claims 1 to 8,
**characterised in that** the parameter-setting operation comprises parameter-setting addresses to characterise the integrated circuit (10).

10. An integrated circuit configuration for performing the method according to one of Claims 1 to 9,
**characterised in that** a supply voltage terminal (12), a reference potential terminal (14) and an output terminal (16) are provided and also an oscillator (20) and an interface device (22) connected to the oscillator (20),
and **in that** the circuit configuration also comprises a memory device (24) and a comparator or detector device (26) switched between the supply voltage terminal (12) and the interface device (22), wherein the interface device (22) communicates with the output terminal (16) and the memory device (24).

11. An integrated circuit configuration according to Claim 10,
**characterised in that** the integrated circuit configuration comprises an analogue circuit part (28) connected to the memory device (24) for setting the analogue circuit part (28) in accordance with the parameter-setting data.

12. An integrated circuit configuration according to Claim 10 or 11,
**characterised in that** the comparator or the detector device (26) has a threshold voltage of roughly +5V.

13. An integrated circuit configuration according to one of Claims 10 to 12,
**characterised in that** the memory device (24) is a non-volatile memory device.

14. An integrated circuit configuration according to one of Claims 10 to 13,
**characterised in that** the integrated circuit configuration comprises at least one sensor (28a), in particular a Hall sensor.

15. An integrated circuit configuration according to one of Claims 10 to 14,
**characterised in that** a parameter-setting command to be applied to the supply voltage terminal (12) and/or the output terminal (16) is determined by a sync bit with following command bits, address bits and data bits.

16. An integrated circuit configuration according to Claim 15,
**characterised in that** four command bits, four address bits and twelve data bits follow the sync bit.

## Revendications

1. Procédé de paramétrage d'un circuit intégré (10) présentant une borne de tension d'alimentation (12), une borne de potentiel de référence (14) ainsi qu'une borne de sortie (16),
**caractérisé en ce que**
le paramétrage est réalisé par application à la borne de tension d'alimentation (12) et/ou à la borne de sortie (16) d'un signal numérique de commande de démarrage suivi de données de paramétrage, en maintenant pendant le processus de paramétrage un niveau de tension supérieur au niveau de tension de service normal du circuit intégré (10) en permanence sur la borne de tension d'alimentation (12) et/ou la borne de sortie (16), ce qui est détecté par un dispositif de détection (26) à l'intérieur du circuit intégré (10).

2. Procédé selon la revendication 1,
**caractérisé en ce que**
le signal de paramétrage est formé par un code qui prévoit un changement de flanc après chaque bit.

3. Procédé selon la revendication 2,
**caractérisé en ce qu'**
un premier état logique d'un bit est déterminé par un changement de flanc supplémentaire sensiblement au milieu de la durée de bit et un deuxième état logique d'un bit est déterminé par un signal restant constant pendant la durée de bit.

4. Procédé selon la revendication 2 ou 3,
**caractérisé en ce qu'**
un oscillateur (20) et une interface (22) sont disposés dans le circuit intégré (10) et traitent une fréquence d'horloge variable prédéterminée du signal de paramétrage, en déterminant en début de chaque bit un créneau temporel pendant lequel on peut s'attendre à un changement de flanc marquant la fin de bit.

5. Procédé selon la revendication 4,
**caractérisé en ce qu'**
après au moins un changement de flanc marquant la fin de bit on détermine la durée d'un bit, et le prochain changement de flanc attendu est attendu de manière décalée de cette durée.

6. Procédé selon la revendication 5,
**caractérisé en ce que**
la durée pour un bit est déterminée à partir de la valeur moyenne d'au moins deux durées de bit successives.

7. Procédé selon l'une quelconque des revendications 1 à 6,
**caractérisé en ce que**
le circuit intégré (10) présente une mémoire (24) non volatile dans laquelle est déposée une instruction de réglage pour au moins un composant de circuit (28) à paramétrer, et le processus de réglage peut être déclenché par cette instruction de réglage par l'intermédiaire des données de paramétrage.

8. Procédé selon l'une quelconque des revendications 1 à 7,
**caractérisé en ce que**
sur la borne de sortie (16) du circuit intégré (10) un signal confirmant le processus de paramétrage est disponible.

9. Procédé selon l'une quelconque des revendications 1 à 8,
**caractérisé en ce que**
le processus de paramétrage présente des adresses de paramétrage pour identifier le circuit intégré (10).

10. Circuit intégré pour la mise en oeuvre du procédé selon l'une quelconque des revendications 1 à 9,
**caractérisé en ce qu'**
une borne de tension d'alimentation (12), une borne de potentiel de référence (14) et une borne de sortie (16) sont prévues ainsi qu'un oscillateur (20) et un dispositif d'interface (22) connecté à l'oscillateur (20), et l'ensemble de circuit présente en outre un dispositif de mémoire (24) et un comparateur ou un dispositif de détection (26) placé entre la borne de tension d'alimentation (12) et le dispositif d'interface (22), le dispositif d'interface (22) étant en liaison avec la borne de sortie (16) et le dispositif de mémoire (24).

11. Circuit intégré selon la revendication 10,
**caractérisé en ce que**
l'ensemble de circuit intégré présente une partie de circuit (28) analogique reliée au dispositif de mémoire (24) pour régler la partie de circuit (28) analogique en fonction des données de paramétrage.

12. Circuit intégré selon la revendication 10 ou 11,
**caractérisé en ce que**
le comparateur ou le dispositif de détection (26) présente une tension de seuil de +5V environ.

13. Circuit intégré selon l'une quelconque des revendications 10 à 12,
**caractérisé en ce que**
le dispositif de mémoire (24) est un dispositif de mémoire non volatile.

14. Circuit intégré selon l'une quelconque des revendications 10 à 13,
**caractérisé en ce que**
l'ensemble de circuit intégré présente au moins un capteur (28a), notamment un capteur Hall.

15. Circuit intégré selon l'une quelconque des revendications 10 à 14,
**caractérisé en ce qu'**
une commande de paramétrage à appliquer sur la borne de tension d'alimentation (12) et/ou la borne de sortie (16) est déterminée par un bit synchronisé suivi de bits de commande, de bits d'adresse et de bits de données.

16. Circuit intégré selon la revendication 15,
**caractérisé en ce que**
le bit synchronisé est suivi de quatre bits de commande, quatre bits d'adresse et quatre bits de données.
